(19) **Europäisches Patentamt / European Patent Office / Office européen des brevets**

(11) **EP 4 653 894 A1**

(12) **EUROPEAN PATENT APPLICATION**
published in accordance with Art. 153(4) EPC

(43) Date of publication:
26.11.2025 Bulletin 2025/48

(21) Application number: 23917634.0

(22) Date of filing: 13.11.2023

(51) International Patent Classification (IPC):
$G01R\ 31/392$ (2019.01)   $G01R\ 31/382$ (2019.01)
$G01R\ 31/385$ (2019.01)   $G01R\ 31/387$ (2019.01)
$H01M\ 10/44$ (2006.01)   $H01M\ 10/48$ (2006.01)
$H02J\ 7/00$ (2006.01)

(52) Cooperative Patent Classification (CPC):
G01R 31/382; G01R 31/385; G01R 31/387;
G01R 31/392; H01M 10/44; H01M 10/48;
H02J 7/00; H02J 13/00; Y02E 60/10

(86) International application number:
PCT/JP2023/040776

(87) International publication number:
WO 2024/154422 (25.07.2024 Gazette 2024/30)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 18.01.2023 JP 2023005686

(71) Applicant: HITACHI HIGH-TECH CORPORATION
Tokyo 105-6409 (JP)

(72) Inventors:
• **INOUE Takeshi**
  **Tokyo 100-8280 (JP)**
• **HIRASAWA Shigeki**
  **Tokyo 105-6409 (JP)**
• **YONEMOTO Masahiro**
  **Tokyo 105-6409 (JP)**
• **HORIKOSHI Nobuya**
  **Tokyo 105-6409 (JP)**
• **MOCHIZUKI Masahito**
  **Tokyo 105-6409 (JP)**
• **SUMIKAWA Yosuke**
  **Tokyo 105-6409 (JP)**
• **KONISHI Hiroaki**
  **Tokyo 100-8280 (JP)**
• **UEDA Suguru**
  **Tokyo 100-8280 (JP)**

(74) Representative: **Mewburn Ellis LLP**
**Aurora Building**
**Counterslip**
**Bristol BS1 6BX (GB)**

(54) **BATTERY DETERIORATION DETERMINATION METHOD AND BATTERY DETERIORATION DETERMINATION DEVICE**

(57)    The invention provides a battery deterioration determination method for estimating an imbalance among cells and an Ah capacity, which are indicators of a deterioration degree of a battery pack, and outputting a warning when the imbalance among cells and the Ah capacity cannot be estimated, even if voltage information on each cell cannot be obtained. The battery deterioration determination method for diagnosing the deterioration degree of the battery pack includes a step (a) of acquiring information on a cell average voltage of the battery pack or a total voltage of the battery pack and a charging current of the battery pack, a step (b) of estimating a CV charging period based on the charging current, and a step (c) of estimating an imbalance relationship among cells and an Ah capacity of the battery pack based on a relationship between the cell average voltage in the CV charging period and a CV voltage of each of the cells.

[FIG. 1]

COMMUNICATION DATA
• DATE AND TIME
• VEHICLE ID
• CURRENT, TOTAL VOLTAGE (EQUIVALENT TO AVERAGE VOLTAGE), SOC OF PACK

CHARGER COMMUNICATION DATA

COMMUNICATION DEVICE

DETERIORATION DIAGNOSIS RESULT

CALCULATION PROCESSING DEVICE (CPU)

CHARGER COMMUNICATION DATA

CV CHARGING PERIOD EXTRACTION UNIT

TABLE SETTING UNIT

Ah CAPACITY AND IMBALANCE DETERMINATION UNIT

MEMORY

CV CHARGING PERIOD AVERAGE VOLTAGE AND CURRENT PATTERN

REFERENCE MATCHING

## Description

Technical Field

The present invention relates to a battery pack diagnosis method and diagnosis device, and particularly relates to a valid technique applied to a battery pack deterioration diagnosis when voltage information on each cell of a battery pack cannot be obtained.

Background Art

An electric vehicle (EV) generally has characteristics different from those of a vehicle in the related art, such as a decrease in battery capacity and a decrease in cruising distance over years. In order to spread the EV to the market, it is important to improve an environment in which a user can use the EV at ease. However, there is a problem that it is very difficult to diagnose a state of an EV battery (in-vehicle battery) that is repeatedly charged and discharged and evaluate a diagnosis result.

Therefore, prior to a full-scale spread of EV, efforts have been made to put into practical use a technique for diagnosing and predicting performance of an EV battery in a short time by utilizing a simplified charging facility. In addition to a remaining capacity and remaining performance of the battery, technical development for grasping an internal state of the battery in detail is also activated.

As a background art of the present technical field, for example, there is a technique as disclosed in PTL 1. PTL 1 discloses "a battery pack diagnosis method and a battery pack diagnosis device that perform a battery deterioration diagnosis using a voltage of each of a plurality of cells constituting the battery pack".

Citation List

Patent Literature

PTL 1: WO2022/024885

Summary of Invention

Technical Problem

In general, a battery pack including a plurality of cells is used for an EV battery. Such a state diagnosis and deterioration diagnosis for the battery pack require information on a state of charge (SOC) of each cell in the battery pack and a voltage of each cell.

However, as described above, the information obtained from a simplified charging facility (charger) is limited, and voltage information on each cell may not be obtained.

In addition, when evaluating a state (imbalanced state) in which voltages of cells in the battery pack are not uniform after the battery pack is fully charged, it is difficult to quantitatively determine whether the imbalance is caused only by an average voltage of the cells, a charging current of the battery pack, and a SOC of the battery pack without using the voltage information of each cell.

In the technique disclosed in PTL 1, it is assumed that a voltage of each cell is used for the deterioration diagnosis of the battery, and it may be difficult to apply the technique to a simplified charging facility (charger).

Therefore, an object of the invention is to provide a battery deterioration determination method and a battery deterioration determination device that estimate an imbalance among cells and an Ah capacity, which are indicators of a deterioration degree of a battery pack, and issue a warning when the imbalance and the Ah capacity cannot be estimated, even if voltage information on each cell cannot be obtained.

Solution to Problem

In order to solve the above problem, a battery deterioration determination method for diagnosing a deterioration degree of a battery pack according to the invention includes a step (a) of acquiring information on a cell average voltage of the battery pack or a total voltage of the battery pack and a charging current of the battery pack, a step (b) of estimating a CV charging period based on the charging current, and a step (c) of estimating an imbalance relationship among cells and an Ah capacity of the battery pack based on a relationship between the cell average voltage in the CV charging period and a CV voltage of each cell.

Further, the invention provides a battery deterioration determination method for diagnosing a deterioration degree of a battery pack, in which the battery pack is a secondary battery such as a lithium ion battery. The battery deterioration determination method includes a step (a) of acquiring information on a cell average voltage of the battery pack or a total voltage of the battery pack and a charging current of the battery pack, a step (b) of estimating a current reduction period based on the charging current, and a step (c) of determining that no imbalance occurs in cells whose cell voltages reach a full charged voltage and determining that an imbalance occurs in the cells whose cell voltages do not reach the full charged voltage during the current reduction period.

A battery deterioration determination device according to the invention includes a communication device configured to acquire data from a charger, a calculation processing device configured to perform calculation processing based on the data; and a storage device configured to store a battery deterioration determination table is stored, in which the communication device acquires, from the charger, information on a cell average voltage of a battery pack or a total voltage of the battery pack and a charging current of the battery pack, and the calculation processing device estimates a CV charging period based on the charging current and estimates an imbalance relationship among cells and an Ah capacity of the battery pack by comparing a cell average voltage and a CV voltage of each of the cells in the estimated CV charging period with the battery deterioration determination table.

Advantageous Effects of Invention

According to the invention, it is possible to provide a battery deterioration determination method and a battery deterioration determination device that estimate an imbalance among cells and an Ah capacity, which are indicators of a deterioration degree of a battery pack, and output a warning when the imbalance among cells and the Ah capacity cannot be estimated, even if voltage information on each cell cannot be obtained.

Accordingly, it is possible to perform a deterioration diagnosis for the battery pack with a relatively simple configuration, and it is possible to contribute to improvement in reliability of the battery pack and an electric vehicle (EV) on which the battery pack is mounted.

Problems, configurations, and effects other than those described above will be clarified by the following description of embodiments.

Brief Description of Drawings

[FIG. 1] FIG. 1 is a diagram illustrating a schematic configuration of a battery deterioration determination device according to Embodiment 1 of the invention.
[FIG. 2] FIG. 2 is a diagram illustrating an example of a battery deterioration determination table.
[FIG. 3] FIG. 3 is a flowchart illustrating a battery deterioration determination method according to Embodiment 1 of the invention.
[FIG. 4] FIG. 4 is a diagram illustrating a voltage and current pattern according to Embodiment 2 of the invention.
[FIG. 5] FIG. 5 is a diagram illustrating a charging method of a CC-CV method.

Description of Embodiments

Hereinafter, embodiments of the invention will be described with reference to the drawings. In the drawings, the same configurations are denoted by the same reference signs, and detailed description of repeating parts is omitted.

[Embodiment 1]

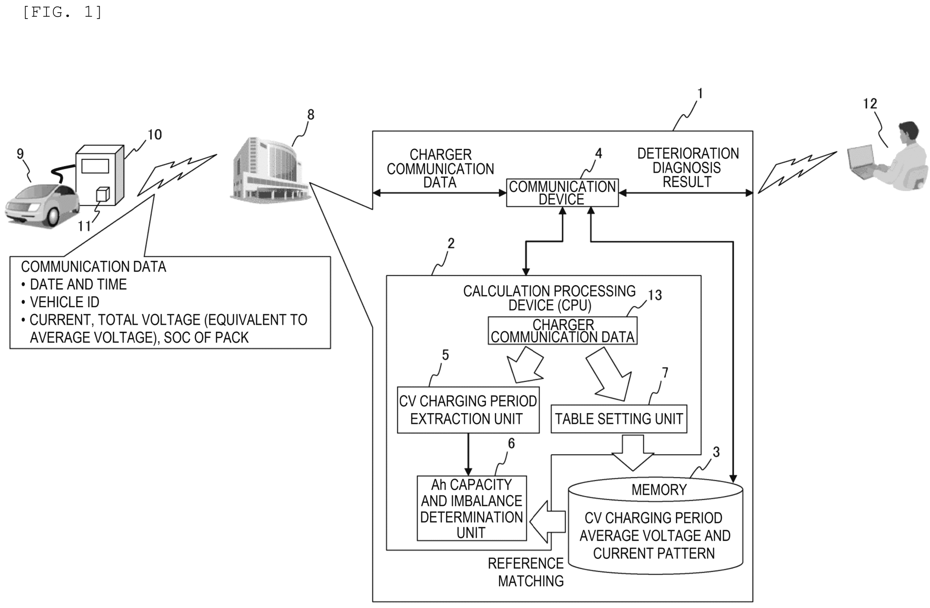

A battery deterioration determination method and a battery deterioration determination device according to Embodiment 1 of the invention will be described with reference to FIGS. 1 to 3 and FIG. 5.

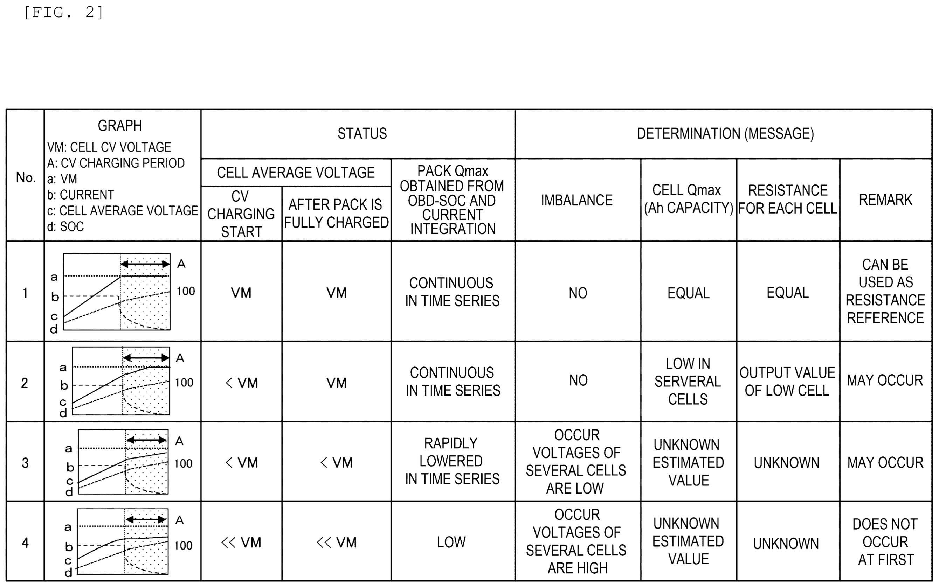

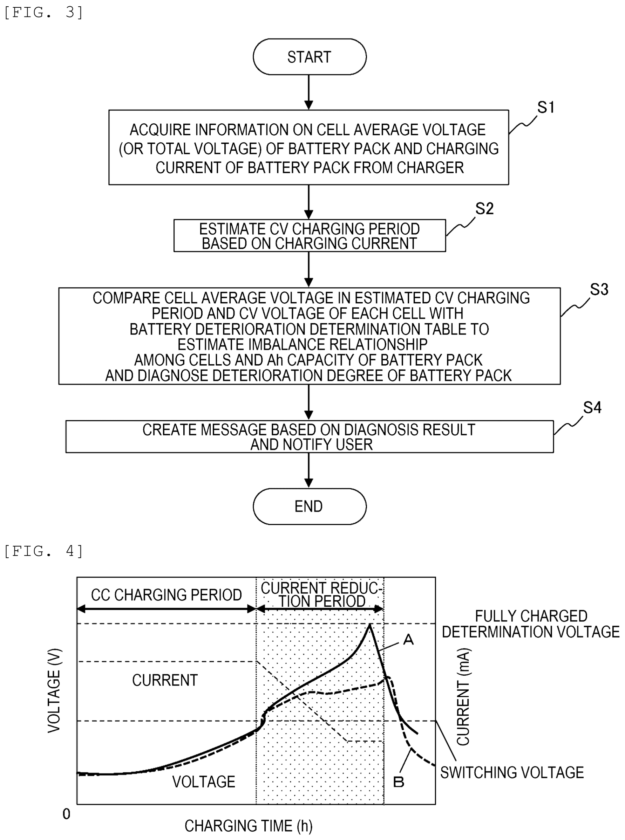

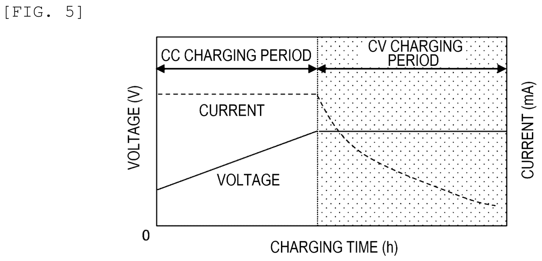

FIG. 1 is a diagram illustrating a schematic configuration of a battery deterioration determination device 1 according to the present embodiment. FIG. 2 is a diagram illustrating an example of a battery deterioration determination table used in the battery deterioration determination device 1 in FIG. 1. FIG. 3 is a flowchart illustrating a battery deterioration determination method according to the present embodiment. FIG. 5 is a diagram illustrating a charging method of a CC-CV method which is a typical charging method of a battery pack in order to facilitate understanding of the invention.

First, a CV charging period serving as a premise of the invention will be described with reference to FIG. 5.

As illustrated in FIG. 5, charging of a battery pack according to a CC-CV method is performed by a combination of constant current charging (CC charging) and constant voltage charging (CV charging). In a CC charging period, charging is continued with a constant current, and a voltage of the battery gradually increases. On the other hand, in a CV charging period, charging is continued with a constant voltage, and a charging current gradually decreases.

That is, in charging of the CC-CV method, the charging is first performed with a constant current (CC), and when a battery voltage reaches a set voltage, control is switched to continue charging with a constant voltage (CV), and the charging is performed until the battery is fully charged while avoiding an overvoltage charging state. Charging by the CC-CV method is widely used.

In the invention, the CV charging period is estimated by extracting a time series from a time when the charging current suddenly drops from a constant value to a time when the battery is fully charged. Then, an ampere hour (Ah) capacity and an imbalance among cells are determined based on a first voltage and a last voltage in the estimated CV charging period.

A configuration and a function of the battery deterioration determination device 1 according to the present embodiment will be described with reference to FIG. 1.

As illustrated in FIG. 1, the battery deterioration determination device 1 in the present embodiment includes, as main components, a calculation processing device 2 such as a central processing unit (CPU) that performs calculation processing based on input data, a storage device (memory) 3 that stores a battery deterioration determination table and the like to be described later in FIG. 2, and a communication device 4 that performs data communication with the outside.

The calculation processing device 2 has functions as a CV charging period extraction unit 5, an Ah capacity and imbalance determination unit 6, and a table setting unit 7.

The battery deterioration determination device 1 is implemented by being installed as an independent device in a center 8 or being stored in a server in the center 8.

The battery deterioration determination device 1 remotely acquires, via a communication device 11 installed in a charger 10, various kinds of data of the charger 10 when an electric vehicle (EV) 9 is charged.

Examples of the communication data acquired from the charger 10 include a charging date and time, a vehicle ID of the EV 9, a charging current of a battery pack, a total voltage of the battery pack, and a SOC of the battery pack. The communication data does not include voltage information of each cell of the battery pack.

The battery deterioration determination device 1 causes the communication device 4 to receive charger communication data transmitted from the communication device 11.

Charger communication data 13 acquired by the communication device 4 is input to the calculation processing device (CPU) 2.

The CV charging period extraction unit 5 acquires information on an average voltage or a total voltage of cells of the battery pack and a charging current of the battery pack based on the input charger communication data 13, and estimates a CV charging period based on the acquired charging current of the battery pack.

The CV charging period estimated by the CV charging period extraction unit 5 is input to the Ah capacity and imbalance determination unit 6.

On the other hand, the table setting unit 7 creates a battery deterioration determination table based on the input charger communication data 13. The battery deterioration determination table created by the table setting unit 7 is merged with past data and is stored in the storage device (memory) 3 as an average voltage and current pattern in the CV charging period.

The Ah capacity and imbalance determination unit 6 reads the average voltage and current pattern in the CV charging period merged with the past data from the storage device (memory) 3 as the battery deterioration determination table, and refers to (matches) the CV charging period estimated by the CV charging period extraction unit 5 to estimate an imbalance relationship among cells of the battery pack and an Ah capacity of the battery pack.

The battery deterioration determination table also includes a determination criterion (message) for performing a deterioration diagnosis on the battery pack, and can diagnose a deterioration degree of the battery pack together with the imbalance relationship among the cells and the Ah capacity.

The imbalance relationship among cells and the Ah capacity estimated by the Ah capacity and imbalance determination unit 6, and a diagnosis result of the deterioration degree of the battery pack are transmitted as a message (warning) to a user 12 such as a driver or a dealer via the communication device 4.

An example of the battery deterioration determination table will be described with reference to FIG. 2. FIG. 2 illustrates a table in which a cell average voltage in the CV charging period and a CV voltage (VM) of each cell are set in advance and a relationship between the imbalance relationship among the cells and the Ah capacity of the battery pack is set for each pattern of the cell average voltage in the CV charging period and the CV voltage of each cell. The determination in FIG. 2 may be made only when the battery pack is fully charged. The determination that the battery pack is fully charged may be made when the OBD-SOC is 100% or when a last charging current is equal to or less than a preset value (for example, 10 A).

FIG. 2 illustrates four patterns of No. 1 to No. 4. In the battery deterioration determination table, a voltage and current graph, a status, and a determination (message) corresponding to each pattern are set.

For example, in the No. 1 pattern, from a voltage and current graph, a cell average voltage in a CV charging period A is a cell CV voltage VM at the start of CV charging and is the same cell CV voltage VM after the pack is fully charged. A pack Qmax obtained from OBD-SOC and current integration is continuous in time series.

In the case of the No. 1 pattern, no imbalance occurs, Qmax (Ah capacity) of each cell is equal, and a resistance of each cell is equal, and it is determined that the pattern can be used as a resistance reference. Although there is a possibility that an imbalance occurs when a voltage is low in only one to several cells, since a voltage gradually increases after the CV charging in this case, it will be described as a pattern to be described later.

In the No. 1 pattern, since no imbalance occurs in each cell and the Ah capacity of each cell is equal, a table indicating a standard open circuit voltage (OCV) and a standard resistance may be created based on data obtained from a charger.

Next, a method for calculating the Ah capacity in the case of No. 1 will be described. In this case, since the last SOC is 100%, a first SOC is obtained from an OCV table (OCV when the SOC is an argument) according to a first voltage. Since cell voltages are equal, all pieces of Qmax are equal, and Qmax is a value obtained by dividing Ah (current integration) from the start of charging to the end of charging by {100 - initial SOC}/100. This is a method obtained according to a voltage, and further OBD-SOC may be used. In this case, Qmax is a value obtained according to electric charges Ah from the start of charging to the end of charging × 100/{last OBD-SOC - first OBD-SOC}.

Subsequently, a standard OCV table is set from the beginning, and may be estimated from past data. This method will be described.

In the case of No. 1, when the OBD-SOC is close to a true value, a data pair of a voltage immediately before the start of charging and a SOC immediately before the start of charging may be extracted, and the OCV may be obtained from a data pair group by function approximation.

Next, a method for creating a standard resistance table will be described. A resistance R (t) at a time t (resistance in a continuously charged state) is obtained as {voltage - OCV(t)}/current by using a current integration time series (q(t)), SOC obtained from Qmax (described as SOC(t). SOC initial value + 100q(t)/Qmax. Instead, OBD-SOC may be used), and an OCV time series (OCV(t)) obtained from SOC. Since SOC(t) at the time t is used, a resistance at SOC(t) is determined.

At the time of obtaining the resistance, since a polarization voltage is not steady when a current change occurs, data is not aggregated during T seconds in which the current change occurs (T is a preset value, for example, 300 seconds). When there is temperature time series (Temp(t)) information in OBD, R(t) is created by function approximation of a two-dimensional table of SOC(t) and Temp (t) .

Next, a method of setting the VM will be described. When the VM is known in advance, a value of the VM is set, but when the VM is unknown, past data is aggregated, and a voltage at the time of switching from the CC charging period to the CV charging period in a state of No. 1 is obtained. In the case of a total voltage, VM is obtained by dividing the total voltage by the number of cells.

Next, a method for calculating a pack capacity will be described. In the case of the No. 1 pattern in which there are two types of pack capacities of an Ah capacity and a Wh capacity, since no imbalance occurs, the Ah capacity of the pack is equal to Qmax of cells. Therefore, the Wh capacity calculation of the pack will be described. In the case of the No. 1 pattern, since no imbalance occurs, the SOC at the end of charging is 100%. The problem is how the SOC of each cell is when the battery pack is empty. At this time, SOCs represented by Formula (1) are obtained. SOCs are in a state where the battery pack is 0, and a lowest voltage is a lowest voltage at the time of discharging illustrated in a cell catalog.

$$\text{OCV(SOCs)} - \text{Id} \times \text{R(SOCs, 25)} = \text{lowest voltage} \quad (1)$$

When SOCs are 0 or less in Formula (1), 0 is set. When the lowest voltage is not illustrated or unknown, SOCs may be simply set to 0.

Subsequently, the Wh capacity (in the case of EV, a discharge side Wh depending on a cruising distance) of each cell is calculated.

At the time of discharging, the Wh capacity of a cell k when it is assumed that a discharge current Id is constant (for example, the catalog Ah capacity of the cell is 1/3) at 25°C is power of Formula (2) which is a value obtained by dividing a value obtained by integrating from SOCs to 100 with SOC by 100 (k = 1, ... the number of cells).

$$\text{power of cell k} = \text{Id} \times \{\text{OCV(SOC)} - \text{Id} \times \text{R(SOC, 25}^\circ\text{C)}\}$$

$$(2)$$

Here, OCV and 25°C resistance are functions already prepared in a table, and numerical integration can be executed. When the Wh capacity of the cell k, which is the numerical integration, is E[k], the Wh capacity of the pack is the sum of the cells k of E[k].

Here, Qmax of each k-th cell is Qmax[k], and the number of a cell having a smallest Qmax is k_min. The SOC of the k-th cell is 100 × {Qmax[k] - Qmax[k_min]}/Qmax[k]. This value is referred to as SOCi[k]. Since the SOC of each cell is discharged at the discharge current Id from 100 to SOCi[k], the Wh capacity of the cell k at 25°C during charging is a value obtained by integrating Id × {OCV(SOC) - Id × R(SOC, 25°C)} with the SOC.

In the No. 2 pattern, from a voltage and current graph, a cell average voltage in the CV charging period A is lower than the cell CV voltage VM at the start of CV charging and is the cell CV voltage VM after the pack is fully charged. A pack Qmax obtained from OBD-SOC and current integration is continuous in time series.

In the case of the No. 2 pattern, it is determined that no imbalance occurs or an imbalance is small when the imbalance occurs, and it is determined that the cell Qmax (Ah capacity) is low in several cells and a value of a cell having a largest resistance is obtained as a resistance of each cell. At this time, a cell having a minimum Qmax is switched to CV charging first. Therefore, the average cell voltage behaves as illustrated in No. 2. Of course, in other situations, for example, when there is a cell that does not reach full charging due to the occurrence of imbalance, the average cell voltage illustrated in No. 2 may be obtained. However, here, it is determined that there may be a state in which the cell Qmax (Ah capacity) is low in several cells.

Next, a method for estimating a minimum value of the cell Qmax and a minimum value of the pack Qmax in the case of No. 2 will be described.

When no imbalance occurs, the representative SOC of the pack generally indicates the SOC of a cell having a minimum Qmax. Therefore, Qmax of the cell having the minimum Qmax is obtained as Qmax = charge amount [Ah] × 100/{ (final OBD-SOC) - (initial OBD-SOC)}.

Since the Ah capacity of the pack is the cell having the minimum Qmax, the Qmax of the cell having the minimum Qmax is the Ah capacity of the pack. Supplementarily, Qmax of a normal cell may be estimated and a user may be notified of the Qmax as a message. This calculation method will be described. In a worst case, only one cell has a minimum Qmax and the other cells have the same Qmax.

An initial cell average voltage before the start of charging can be approximated to the OCV of cells having the same Qmax. Therefore, Qmax, which is larger than the SOC(SOCi) obtained from a cell average voltage immediately before the start of charging, is obtained as Qmax = charge amount [Ah] × 100/{100 - SOCi}.

In the No. 3 pattern, from a voltage and current graph, an average voltage of cells in the CV charging period A is lower than the cell CV voltage VM at the start of CV charging and is lower than the cell CV voltage VM after the pack is fully charged. Further, the pack Qmax obtained from OBD-SOC and current integration is rapidly lowered in time series.

In the case of the No. 3 pattern, it is determined that an imbalance occurs, voltages of several cells are low, and a resistance for each cell is unknown. Since the voltages of several cells are low, cell voltages increase even in the CV charging period, but since a cell average voltage does not completely reach the VM in the last CV period, the pattern is determined as the No. 3 pattern.

An estimated value of the pack Qmax is estimated as pack Qmax = charging charges × 100/{100 - SOC (cell average voltage immediately before charging)} by approximating a cell in which the cell average voltage immediately before the start of charging indicates a high SOC at the beginning.

Since it is difficult to reflect low cell voltage information of several cell voltages in the average cell voltage in a final charging state, it is difficult to estimate the imbalance in a state at the end of charging. However, the OBD-SOC at the beginning of charging is rate-controlled in a cell having a minimum SOC and is output. Therefore, it is possible to estimate a worst case of the imbalance assuming that Qmax is equal. The SOC in Formula (3) is obtained from the imbalance, and a message indicating that "voltages of several cells corresponding to the SOC in Formula (3) are low as a worst value when the pack is fully charged" is output. The imbalance SOC is a capacity ratio of the battery pack that is recovered by eliminating the imbalance.

imbalance SOC = OBD-SOC - SOC (average cell voltage immediately before charging) (3)         (3)

In the No. 4 pattern, from a voltage and current graph, an average voltage of cells in the CV charging period A is further lower than the cell CV voltage VM at the start of CV charging and is further lower than the cell CV voltage VM after the pack is fully charged. Although the pack Qmax obtained from the OBD-SOC and the current integration is considered to be low, the pack Qmax obtained from the OBD-SOC and the current integration is output as an estimated value.

In the case of the No. 4 pattern, it is determined that an imbalance occurs, voltages of several cells are high, and a resistance for each cell is unknown. The No. 4 pattern is a pattern in which an overwhelmingly large number of cells are not fully charged and the average cell voltage is lower than VM at the end of charging.

When the voltage of only one to several cells is high, the voltage after the end of charging is considered. The reason is that, although several cells have SOC 100, most cells have SOCs estimated from the average cell voltage after the end of charging based on the OCV table. Therefore, the SOC is estimated according to Formula (4), and a message indicating that "several cells have high voltages corresponding to the SOC in Formula (4) as a worst value when the pack is fully charged" is output. The imbalance SOC is a capacity ratio of the battery pack that is recovered by eliminating the imbalance.

imbalance SOC = 100 - SOC (average cell voltage after charging is ended) (4)                    (4)

The battery deterioration determination method executed by the battery deterioration determination device 1 according to the present embodiment will be described with reference to FIG. 3.

When processing of the battery deterioration determination device 1 starts, first, in step S1, information on a cell average voltage (or total voltage) of a battery pack and a charging current of the battery pack is acquired from a charger.

Next, in step S2, a CV charging period is estimated based on the acquired charging current of the battery pack. In this method, the current is cut out after a value decreases from a constant state (CC charging period).

Subsequently, in step S3, a cell average voltage in the estimated CV charging period and a CV voltage of each cell are compared with the battery deterioration determination table (a state illustrated in FIG. 2) to estimate an imbalance relationship among cells and an Ah capacity of the battery pack and diagnose a deterioration degree of the battery pack.

Finally, in step S4, a message is created based on a diagnosis result and a user is notified of the message, and the processing ends.

In step S4, the imbalance relationship among the cells and the Ah capacity of the battery pack may be classified into levels to set a threshold for each level, and the user may be alerted when the imbalance relationship or the Ah capacity exceeds the threshold for each level.

According to the battery deterioration determination method and the battery deterioration determination device in the present embodiment described above, even when the voltage information of each cell cannot be obtained, it is possible to estimate the imbalance among cells and the Ah capacity, which are indicators of a deterioration degree of the battery pack.

[Embodiment 2]

A battery deterioration determination method according to Embodiment 2 of the invention will be described with reference to FIG. 4. FIG. 4 is a diagram showing a voltage and current pattern according to the present embodiment.

Although the first embodiment has been described on the assumption that the battery pack is charged according to the CC-CV method, a battery deterioration determination method of another charging method will be described below in the present embodiment. The present charging method may be used for a lithium ion battery other than LFP and LFP, and the following charging method may be used.

An LFP battery is a kind of lithium ion secondary battery in which lithium (Li), iron (Fe), and phosphorus (P) are used as materials on a positive electrode side. In the LFP battery, instead of the CC-CV charging method, a charging method in which a current is reduced when a voltage of a cell increases from CC charging is often adopted. The period in which the current is reduced is referred to as a current reduction period. As illustrated in FIG. 4, in the charging, charging is first performed with a constant current (CC), and the current is linearly reduced in the current reduction period. Finally, when a cell voltage reaches a predetermined threshold voltage (for example, 3.7 V), the charging ends.

A method for estimating the current reduction period based on the charging current is the same as that in Embodiment 1 (steps S1 and S2 in FIG. 3).

Next, the current reduction period is estimated based on the charging current. In the current reduction period, when all cells are in a fully charged pattern (A in FIG. 4), it is determined that no imbalance occurs.

On the other hand, in the case of a pattern in which a cell voltage is less than a full charged voltage (B in FIG. 4), that is, in a case where a voltage pattern is blunt, it is determined that an imbalance occurs.

The invention is not limited to the embodiments described above, and includes various modifications. For example, the embodiments described above have been described in detail to facilitate understanding of the invention, and the invention is not necessarily limited to those including all the configurations described above. A part of a configuration of a certain embodiment can be replaced with a configuration of another embodiment, and the configuration of another embodiment can be added to a configuration of a certain embodiment. A part of a configuration of each embodiment may be added to, deleted from, or replaced with another configuration.

Reference Signs List

1 battery deterioration determination device
2 calculation processing device (CPU)
3 storage device (memory)
4 communication device
5 CV charging period extraction unit

6 Ah capacity and imbalance determination unit
7 table setting unit
8 center (server)
9 electric vehicle (EV)
10 charger
11 communication device
12 user
13 charger communication data

**Claims**

1. A battery deterioration determination method for diagnosing a deterioration degree of a battery pack, the battery deterioration determination method comprising:

   a step (a) of acquiring information on a cell average voltage of the battery pack or a total voltage of the battery pack and a charging current of the battery pack;
   a step (b) of estimating a CV charging period based on the charging current; and
   a step (c) of estimating an imbalance relationship among cells and an Ah capacity of the battery pack based on a relationship between the cell average voltage in the CV charging period and a CV voltage of each of the cells.

2. The battery deterioration determination method according to claim 1, wherein
   in the step (c), the cell average voltage in the CV charging period and the CV voltage of each of the cells are compared with a table in which a relationship among the cell average voltage in the CV charging period, the CV voltage of each of the cells, the imbalance relationship among the cells, and the Ah capacity of the battery pack is set in advance, thereby estimating the imbalance relationship among the cells and the Ah capacity of the battery pack or diagnosing the deterioration degree of the battery pack.

3. A battery deterioration determination method, in which

   in a battery charging method, CC-CV charging is not used during charging, and a period is provided in which a charging current is not constant and is reduced after CC charging, and the period is designed as a current reduction period in which the charging current is not constant and is reduced when it is determined that a certain cell is full charged and charging of a battery pack is stopped when the cell reaches a constant voltage,
   the battery deterioration determination method comprising:

   a step (a) of acquiring information on a cell average voltage of the battery pack or a total voltage of the battery pack and a charging current of the battery pack;
   a step (b) of estimating the current reduction period based on the charging current; and
   a step (c) of determining that no imbalance occurs in cells whose cell voltages reach a full charged voltage and determining that an imbalance occurs in cells whose cell voltages do not reach the full charged voltage in the current reduction period.

4. The battery deterioration determination method according to any one of claims 1 to 3, wherein
   in the step (a), information on the cell average voltage or the total voltage and the charging current when the battery pack is charged by a charger is acquired.

5. The battery deterioration determination method according to any one of claims 1 to 3, wherein
   a message is created based on a diagnosis result and a user is notified of the message.

6. The battery deterioration determination method according to any one of claims 1 to 3, wherein
   the imbalance relationship among the cells and the Ah capacity of the battery pack are classified into levels to set a threshold for each of the levels, and a user is alerted when the imbalance relationship or the Ah capacity exceeds the threshold for each of the levels.

7. The battery deterioration determination method according to any one of claims 1 to 3, further comprising:
   creating a table indicating a standard OCV and a standard resistance based on data obtained from the charger when no imbalance occurs in the cells and Ah capacities of the cells are equal.

8. The battery deterioration determination method according to any one of claims 1 to 3, wherein
the information on the cell average voltage or the total voltage and the charging current is remotely acquired from the charger via a communication device.

9. A battery deterioration determination device comprising:

a communication device configured to acquire data from a charger;
a calculation processing device configured to perform calculation processing based on the data; and
a storage device configured to store a battery deterioration determination table, wherein
the communication device acquires, from the charger, information on a cell average voltage of a battery pack or a total voltage of the battery pack and a charging current of the battery pack, and
the calculation processing device estimates a CV charging period based on the charging current and estimates an imbalance relationship among cells and an Ah capacity of the battery pack by comparing the cell average voltage and a CV voltage of each of the cells in the estimated CV charging period with the battery deterioration determination table.

[FIG. 1]

COMMUNICATION DATA
- DATE AND TIME
- VEHICLE ID
- CURRENT, TOTAL VOLTAGE (EQUIVALENT TO AVERAGE VOLTAGE), SOC OF PACK

CHARGER COMMUNICATION DATA

COMMUNICATION DEVICE

DETERIORATION DIAGNOSIS RESULT

CALCULATION PROCESSING DEVICE (CPU)

CHARGER COMMUNICATION DATA

CV CHARGING PERIOD EXTRACTION UNIT

TABLE SETTING UNIT

Ah CAPACITY AND IMBALANCE DETERMINATION UNIT

MEMORY

CV CHARGING PERIOD AVERAGE VOLTAGE AND CURRENT PATTERN

REFERENCE MATCHING

[FIG. 2]

| No. | GRAPH<br>VM: CELL CV VOLTAGE<br>A: CV CHARGING PERIOD<br>a: VM<br>b: CURRENT<br>c: CELL AVERAGE VOLTAGE<br>d: SOC | STATUS | | | DETERMINATION (MESSAGE) | | | |
|---|---|---|---|---|---|---|---|---|
| | | CELL AVERAGE VOLTAGE | | PACK Qmax OBTAINED FROM OBD-SOC AND CURRENT INTEGRATION | IMBALANCE | CELL Qmax (Ah CAPACITY) | RESISTANCE FOR EACH CELL | REMARK |
| | | CV CHARGING START | AFTER PACK IS FULLY CHARGED | | | | | |
| 1 | | VM | VM | CONTINUOUS IN TIME SERIES | NO | EQUAL | EQUAL | CAN BE USED AS RESISTANCE REFERENCE |
| 2 | | < VM | VM | CONTINUOUS IN TIME SERIES | NO | LOW IN SERVERAL CELLS | OUTPUT VALUE OF LOW CELL | MAY OCCUR |
| 3 | | < VM | < VM | RAPIDLY LOWERED IN TIME SERIES | OCCUR VOLTAGES OF SEVERAL CELLS ARE LOW | UNKNOWN ESTIMATED VALUE | UNKNOWN | MAY OCCUR |
| 4 | | << VM | << VM | LOW | OCCUR VOLTAGES OF SEVERAL CELLS ARE HIGH | UNKNOWN ESTIMATED VALUE | UNKNOWN | DOES NOT OCCUR AT FIRST |

EP 4 653 894 A1

12

[FIG. 3]

[FIG. 4]

[FIG. 5]

## INTERNATIONAL SEARCH REPORT

| International application No. |
| --- |
| **PCT/JP2023/040776** |

**A.    CLASSIFICATION OF SUBJECT MATTER**

*G01R 31/392*(2019.01)i; *G01R 31/382*(2019.01)i; *G01R 31/385*(2019.01)i; *G01R 31/387*(2019.01)i; *H01M 10/44*(2006.01)i; *H01M 10/48*(2006.01)i; *H02J 7/00*(2006.01)i
FI:    G01R31/392; G01R31/385; G01R31/387; G01R31/382; H02J7/00 Q; H01M10/44 Q; H01M10/48 P

According to International Patent Classification (IPC) or to both national classification and IPC

**B.    FIELDS SEARCHED**

Minimum documentation searched (classification system followed by classification symbols)

G01R31/36-396; H01M10/4-10/48; H02J7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| A | WO 2022/024885 A1 (HITACHI HIGH-TECH CORPORATION) 03 February 2022 (2022-02-03) entire text | 1-9 |
| A | US 2021/0111568 A1 (SAMSUNG SDI CO., LTD.) 15 April 2021 (2021-04-15) paragraphs [0146]-[0158], [0172]-[0183], fig. 10, 12 | 1-9 |
| A | JP 2003-173823 A (SANYO ELECTRIC CO., LTD.) 20 June 2003 (2003-06-20) entire text | 1-9 |
| A | CN 101807729 A (ZHANGJIAGANG RUINENG TECHNOLOGY CO., LTD.) 18 August 2010 (2010-08-18) entire text | 3-4, 8 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **05 January 2024** | **23 January 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2023/040776**

| Patent document cited in search report | | | Publication date (day/month/year) | Patent family member(s) | | | Publication date (day/month/year) |
|---|---|---|---|---|---|---|---|
| WO | 2022/024885 | A1 | 03 February 2022 | US | 2023/0204675 | A1 | |
| | | | | EP | 4191745 | A1 | |
| | | | | CN | 115835974 | A | |
| US | 2021/0111568 | A1 | 15 April 2021 | EP | 3806228 | A1 | |
| | | | | KR | 10-2021-0042679 | A | |
| | | | | CN | 112653204 | A | |
| | | | | TW | 202115421 | A | |
| JP | 2003-173823 | A | 20 June 2003 | US | 2003/0085690 | A1 | |
| CN | 101807729 | A | 18 August 2010 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• WO 2022024885 A